# EUROPEAN PATENT APPLICATION

(11) **EP 2 221 880 A2**
(43) Date of publication of application: **25.08.2010**
(21) Application number: 09251541.0
(22) Date of filing: 11.06.2009
(51) Int. Cl.: H01L 31/048

(54) **Encapsulation process for thin-film solar cells**

(30) Priority: 24.02.2009 CN 200910046537
(71) Applicant: Xiaolin Sha, Shanghai 200336 (CN)
(72) Inventor: Xiaolin Sha, Shanghai 200336 (CN)
(74) Representative: Roberts, Mark Peter

(57) **Abstract**

An encapsulation process for thin-film solar cells comprises the steps of: coating a resin on an electrode of a TCO glass of a thin film solar cell by a coating machine, and coating edges of the thin film solar cell synchronously by a frame coating machine. The resin has a predetermined rigidity, stickiness, aging resistance, abrasion resistance and puncture resistance after solidification.

## Description

### Background of the Present Invention

### Field of Invention

The present invention relates to an encapsulation process for thin-film solar cells including amorphous silicon thin-film cells, CIGS thin-film cells, Chromium (III) antimonide thin-film cells and flexible thin-film cells.

### Description of Related Arts

At present, all the thin-film solar cells in, the world employ two layers of hard material, with heat sealing adhesive between them. In high temperature and vacuum condition, sealing the layers by laminating the conductive layer of the thin-film cells, it will prevent the conductive layer from contacting with the outer, and protect the conductive layer from oxidation, so as to ensure the long term of generating film and the life time of the thin-film solar cells, and enhance the mechanical strength of the thin-film cells. At present, in the lamination of the two layers of the thin-film solar cells, there are two kinds of material and production methods: First, the surface layer is made of conductive glass, and the back panel is made of common glass (some of the back panels are toughened glass), and in the middle there is EVA or other heat sealing adhesives. Second, the surface layer is made of conductive glass, and the back panel is PET complex film with aluminum film (type 1XAPOW, 1QABO), and in the middle there is EVA or other heat sealing adhesives. In vacuum condition and high temperature, with laminating machine, the heat sealing adhesives makes the surface and back layer glue together. But at present, there are many drawbacks with the processing methods many thin-film manufactures use, such as two layers of glass with EVA and other heat sealing adhesives, or single conductive glass, PET complex film with aluminum film (type 1XAPOW, 1QABO) with EVA and other heat sealing adhesives:
1. The glass cracks and breaks easily. The reasons are as follows: First, the thickness of the glass used for thin-film cells is usually 3.2mm or 4mm, at the most 5mm. If the glass is too thick, it will increase the weight of the thin-film cells. It will not only increase the transportation weight, but also increase the supporting weight when it is used on the roof of a building or house. But if using glass of 3.2 mm or 4 mm thick, for it's very thin, it will easily crack in the edging, radiusing process, especially in the process of superposition, and lamination. At present, a few factories use toughened glass, but it will increase the production cost, and most of the conductive glass will do the film coating on line. It is very complicated for us to do the film coating and toughening treatment on line at the same time. So at present, most of the manufacturers use common glass in the production process, the conductive glass also has the problem of crack. Second, in assembling, transportation, installation, electricity generating period, for vibration and curve and other reasons, the conductive glass is easy to crack. Third, the life time of thin-film solar cells usually need to reach about 20 years. In the long term of use period, high temperature, hailstone, birds or discards can all cause shock to the thin-film cell and results in crack.
   When there is crack in the thin-film solar cells, rain, steam will go into the inner layer of the cell, and quickly corrode the conducting film, and result in the oxidation of the conducting film, and destroy the conducting layer, and make the generating power fall, and the cell will lose generating ability fast, and the thin-film cell will become a waste product. In the production process, crack of glass will produce waste product, which will seriously affect the cost; while in installation and long term of using, if there is crack, it will cause serious harm to the generating system, and increase the maintenance cost. As a result, the crack of the thin-film solar cell glass is the main drawback and prominent problem in the production and use of the thin-film cells.
2. There will be too many production processes, and high cost for the double lamination. At present, after film coating of the thin-film cells, we need to laminate the two layers of glass or the single glass and PET complex film with aluminum film(type IX APOW, 1QABO), these process is not only complicated, but also will increase the cost, because we have to use EVA and other adhesives and backing materials. On the other side, it is very heavy to use two layers of glass, and the volume is very big, which increases the cost of packing, transportation and installation.
3. At present, most of the thin-film cells use two layers of glass [one layer of glass and one layer of PET complex film with aluminum film (type 1XAPOW, 1QABO)] with one layer of EVA or other adhesives in the middle. In the production period, if we can't control the vacuum condition of the lamination equipment, temperature, and flatness well, or for ageing of the adhesives and other reasons, it will cause bad sealing to the surface, especially the edge, and easily let the water enter into the inner layer and result in the reduction of the power. In order to make sure that during 20 years of life time, the water will not enter the inner layer and affect the conductive layer, we have to do waterproof treatment with the edge. The production technique is also quite complicated, and the requirement is high. At the same time, it increases the cost of the thin-film solar cells using edge sealing material (such as silica gel).

In short, the present production technique the thin-film solar cells uses, leads to serious drawbacks of product quality and long term use, and largely increases the cost. In order to solve these problems, this invention raises an encapsulation technique and material.

### Summary of the Present Invention

A main desire of the present invention is to provide an encapsulation process for thin-film solar cells, comprising the steps of: coating high performance resin on top of the TCO glass, as well as the areas of the edges, it can be done with fabric coating continuous equipment. The present invention of the resin has the following advantages:
1. After resin being solid, it becomes very strong, it cannot even be cut by knives. Cut and abrasion resistance of the solidification resin is stronger than that of metal sheet. The resin completely sticks to the electrode of the TCO glass, and cannot be separated. Meanwhile, the resin and glass become one layer without any bubble therebetween so as to ensure long term usage of solar cell, without worrying about air or water goes into the layers. As it has been also coated at all the standing areas, no air or water can penetrate from the edges. The present invention assures the resin and TCO glass cannot be split, therefore there is less chance for water or air penetration, which ensures least degradation of the performances of the cell.
2. The resin resists to rain, sunlight, high temperatures, ensures least degradation under bad weather conditions, therefore guarantees 20 years performance of the solar cells.
3. As this invention has very high cut and abrasion resistance, additionally we will use tempered TCO glass, which means both materials are extremely strong and has high puncture resistance, thus, will not be damaged if encounter hailstone or bird droppings or any other objects, will not break under high temperature, consequently, avoid breakage damage.
4. The invention will drastically reduce production costs. (A) It will reduce production process drastically. It eliminates encapsulation process, and reduces all the electricity, water and labor costs during the process as well as equipment investment. (B) Traditional process of the TCO glass, to avoid de-lamination, requires encapsulation, a width of cut edges is 1.5cm For example, a cell with size of 110cm*140cm, a cut area is 75cm². As the cut edge will not have performance, it reduces drastically the overall performance of the cells. Using the present technology, as it longer uses EVA, then a width of the cut edge is reduced to 0.5cm, taking again the same size, the cut area is 25cm², only 33% loss of the old technique. Therefore, it enlarges the performing areas. (C) Using high performance resin, with back glass or PET complex film with aluminum film and EVA, it saves materials costs and reduce overall cost of the solar cells. (D) Using this technology, a thickness of the resin is 1.5mm, compared to traditional 3.2mm TCO glass and 4mm back glass, overall weight and size are reduced by 40%, therefore reduce the whole weight and dimension of the cells, consequently reduce packing and transportation costs and costs of brackets of solar farms, reduce the supporting weight for the roof and other building materials, and reduce the installation costs. Considering the above mentioned conditions, it reduces drastically the production, transportation and installation cost of the thin film cells, it makes the cost of solar energy close to conventional energy, make the replacement possible.
5. Using the present technology, cell can become transparent, therefore more suitable for building integration purpose. The resin is transparent liquid, remains transparent after solidification. Together with transparent plating materials of electrode of the TCO glass, it makes transparent BIPV achievable and broadens the market potential of thin film solar cells.

Accordingly, in order to accomplish the above object, the present invention provides an encapsulation process for thin-film solar cells, comprising the steps of: coating a resin on an electrode of a TCO glass of a thin film solar cell by a coating machine; coating edges of the cell synchronously by a frame coating machine; installing a junction box; making the resin solidification by a curing machine; and testing, packing and sending the production to warehouse.

These and other objectives, features, and advantages of the present invention will become apparent from the following detailed description, and the appended claims.

### Detailed Description of the Preferred Embodiment

An encapsulation process for thin-film solar cells according to a preferred embodiment of the present invention is illustrated, in which the encapsulation process for thin-film solar cells comprises the steps of: coating a resin on an electrode of a TCO glass of a thin film solar cell by a coating machine; coating edges of the cell synchronously by a frame coating machine; installing a junction box; making the resin solidification by a curing machine to get a production; and testing, packing and sending the production to warehouse.

The resin has a high performance. After the resin being solidified, it becomes very strong, and cannot even be cut by knives. Cut and abrasion resistance of the solidified resin is stronger than metal sheet. The solidified resin completely sticks to the electrode of the TCO glass, and cannot be separated. Meanwhile, the resin and the TCO glass become one layer without any bubble therebetween so as to ensure a long term usage of a solar cell, without worrying about air or water goes into the layers. As the glass has been also coated at all the edge portions thereof, no air or water can penetrate from the edge portions. The present invention assures the resin and TCO glass cannot be split, therefore there is less chance for water or air penetration, which ensures least degradation of the performances of the cell.

Furthermore, the high performance resin resists to rain, sunlight, high temperatures, and ensures least degradation under bad weather conditions to guarantee 20 years performance of the solar cells.

As the present invention has very high cut and abrasion resistance, additionally we will use tempered TCO glass, which means both materials are extremely strong and has high puncture resistance so that the solar cell will not be damaged under hailstone, bird or any other objects hit, and will not break under high temperature, so as to avoid breakage damage.

Furthermore, the electrode of the TCO glass of thin film solar cell has a light trapping layer coating thereon to enhance an ability of light trapping of the thin film solar cell.

A thickness of the coating resin is 1.5mm, compared to traditional 3.2mm TCO glass and 4mm back glass, overall weight and size of the present invention are reduced by 40%, therefore reduce the whole weight and dimension of the cell, accordingly reduce packing and transportation costs, reduce the supporting weight for the bracket of a solar farm, roof and other buildings, and reduce the installation costs. Considering the above mentioned conditions, it reduces drastically the production, transportation and installation cost of the thin film cell, it makes the cost of solar energy close to conventional energy, make the replacement possible.

Traditional process of the TCO glass, to avoid de-lamination, requires encapsulation, then a width of cut edges is 1.5cm. For example, a cell with size of 110cm* 140cm, a cut area thereof is 75cm². As the cut edge will not have performance, it reduces drastically the overall performance of the cell. In the present invention, the width of the cut edges is reduced to 0.5cm without using EVA. Taking again the same size, the cut area is 25cm², only 33% loss of the traditional technique to enlarge the performing areas and increase the power of the solar cell.

In the present invention, the cell can become transparent, therefore more suitable for building integration purpose. The high performance resin is transparent liquid, and remains transparent after solidification. Together with transparent plating materials of electrode of the TCO glass, it makes transparent BIPV achievable and broadens the market potential of the thin film solar cell.

One skilled in the art will understand that the embodiment of the present invention as shown in the drawings and described above is exemplary only and not intended to be limiting.

It will thus be seen that the objects of the present invention have been fully and effectively accomplished. It embodiments have been shown and described for the purposes of illustrating the functional and structural principles of the present invention and is subject to change without departure from such principles. Therefore, this invention includes all modifications encompassed within the spirit and scope of the following claims.

## Claims

1. An encapsulation process for thin-film solar cells comprises the steps of: coating a resin on an electrode of a TCO glass of a thin film solar cell by a coating machine; coating edges of said thin film solar cell synchronously by a frame coating machine; installing a junction box; and making said resin solidification by a curing machine to get a production piece.

2. The encapsulation process for thin-film solar cells as recited in claim 1, further comprising testing, packing and sending said production piece to a warehouse.

3. The encapsulation process for thin-film solar cells as recited in claim 1 or 2, wherein said resin is a high performance resin, having a predetermined rigidity, stickiness, aging resistance, abrasion resistance and puncture resistance after solidification.

4. The encapsulation process for thin-film solar cells as recited in any one of the preceding claims, wherein said electrode of said TCO glass of said thin film solar cell has a light trapping layer coating thereon to enhance an ability of light trapping of said thin film solar cell.

5. The encapsulation process for thin-film solar cells as recited in any one of the preceding claims, wherein a thickness of said coating resin is 1.5mm.

6. The encapsulation process for thin-film solar cells as recited in any one of the preceding claims, wherein a width of each of said coating edges is 0.5cm.

7. The encapsulation process for thin-film solar cells as recited in any one of the preceding claims, wherein said electrode of said TCO glass is made of transparent plating materials, and said high performance resin is a transparent liquid.

8. A thin-film solar cell produced according to the steps of any one of the preceding claims, comprising a TCO glass having two back electrodes coated with a resin thereon, and coating edges coated with said resin thereon, wherein a thickness of said coating resin is 1.5mm, and a width of each of said coating edges is 0.5cm.

9. A thin-film solar cell comprising a TCO glass having two back electrodes coated with a resin thereon, and coating edges coated with said resin thereon, wherein a thickness of said coating resin is 1.5mm, and a width of each of said coating edges is 0.5cm.
